# FASCICULE DE BREVET EUROPEEN

(11) **EP 0 481 948 B1**
(45) Date de publication et mention de la délivrance du brevet: **04.03.1998**
(21) Numéro de dépôt: 91870162.4
(22) Date de dépôt: 11.10.1991
(51) Int. Cl.: H05K 9/00

(54) **Cabine électrique métallique sans tension de pas ou de contact**
Elektrische Metallkabine ohne Schritt- oder Kontaktspannung
Electrical metal cabin without step potential or contact voltage

(30) Priorité: 15.10.1990 BE 9000973
(43) Date de publication de la demande: 22.04.1992
(73) Titulaire: BIOVIVAT, Theux (Polleur) (BE); Lincé, Marcel, B-4800 Verviers (BE)
(72) Inventeur: DEVAUX, Francois, 4910 Theux (Polleur) (BE); LINCE, Marcel, 4800 Verviers (BE)
(74) Mandataire: Claeys, Pierre

(56) Documents cités:
- EP-A- 0 048 488
- DE-A- 2 316 933
- DE-A- 3 809 323
- DE-U- 9 017 344
- US-A- 3 832 605

## Description

La présente invention concerne les cabines électriques métalliques et est relative à une telle cabine, exempte de tout danger lié à la tension de pas ou de contact ou exempte de dangers liés au potentiel de paroi perçu par un être vivant foulant le sol et entrant en contact avec ses parois.

La DE-A-3809323 décrit une cabine de protection contre des champs magnétiques à haute fréquence, en particulier pour des instruments de tomographie à spin nucléaire, les parois de la cabine comportant une matière de base, par exemple en comprimé de copeaux de bois, et un écran de protection métallique fixé par des vis métalliques traversant la matière de base.

La DE-A-2316933 décrit un conteneur mobile dont la matière n'est pas explicitée, agencé pour y loger des équipements électriques, en particulier destinés à des examens et des mesures, et agencé pour protéger ces équipements contre des champs électromagnétiques de fréquences élevées et très élevées, une cabine autoportante et étanche aux hautes fréquences étant construite dans l'espace interne du conteneur.

Le US-A-3.832.605 décrit un logement préfabriqué destiné à des moyens de commutation électrique et constitué de panneaux métalliques, des panneaux isolants par exemple en uréthanne ou en fibre de verre pouvant être placés entre un panneau métallique précité et une paroi métallique de doublure de ce dernier.

On connaît des cas d'accidents mortels liés au phénomène de tension de pas ou de contact pour des cabines métalliques.

C'est pourquoi il a paru avantageux de réaliser une cabine électrique métallique, dont les parois assurent, en plus des fonctions classiques de cage de Faraday et de barrage thermique ou cinétique, la fonction permanente de barrage vis-à-vis de l'établissement d'un gradient de potentiel entre la paroi métallique et le sol via le corps d'un être humain entrant en contact avec cette paroi.

De plus, il a paru opportun de doubler cet avantage par un système de mesure de la résistance de l'électrode de terre qui, non seulement, bloque l'accès de la cabine en cas de déféctuosité de celle-ci mais déclenche aussi un signal d'avertissement indiquant la présence d'une anomalie.

Une cabine électrique métallique suivant l'invention est caractérisée en ce que ses parois sont constituées d'au moins deux éléments, dont l'un est conducteur et l'autre ou les autres isolants électriquement.

Suivant l'invention l'élément conducteur est constitué de panneaux métalliques reliés à la terre et l'élément isolant est constitué par une couche isolante électriquement prévue sur une ou les deux faces des panneaux métalliques.

Suivant une réalisation la ou les couches isolantes sont en contact direct avec les panneaux métalliques et adhèrent à ceux-ci.

Suivant une autre réalisation la ou les couches isolantes sont espacées des panneaux métalliques et, éventuellement, reliées à ceux-ci par des ponts en matière diélectrique.

Une cabine électrique métallique suivant l'invention est encore caractérisée en ce que l'enveloppe métallique constitutive est coiffée d'un toit solidaire de sa base, qui suivant une réalisation est métallique et suivant une autre réalisation en matière isolante électriquement.

Encore suivant l'invention la cabine électrique métallique est équipée de moyens permettant l'évacuation des calories générées dans son enceinte.

L'invention est décrite maintenant avec plus de détails sur la base des dessins annexés, à titre d'exemples uniquement, montrant en :
Figures 1A, 1B, 1C schématiquement la possibilité d'agencement totalement indépendant du panneau métallique et de la ou des couches isolantes devant former une paroi de la cabine ;
Figures 2A, 2B, 2C schématiquement la possibilité d'agencement jointif ;
Figures 3A, 3B, 3C schématiquement la possibilité d'agencement avec liaison par ponts diélectriques ;
Figures 4 et 5 une vue partielle en perspective d'une paroi de cabine respectivement dans sa partie supérieure et dans sa partie inférieure ;
Figure 6 une vue partielle en perspective d'une jonction de parois de cabine, et
Figure 7 une vue partielle en perspective d'une toiture de cabine électrique métallique suivant l'invention.

Chaque paroi de la cabine est formée d'au moins deux éléments, un élément conducteur 1 et un ou plusieurs éléments isolants 2.

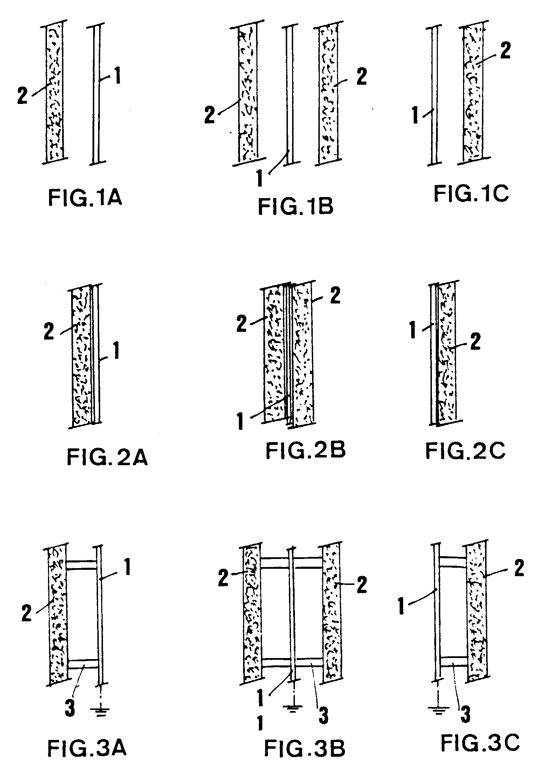

On a représenté dans les figures 1 à 3 trois réalisations de paroi comportant respectivement des éléments 1 et 2 indépendants, des éléments 1 et 2 contigüs et des éléments 1 et 2 avec ponts diélectriques 3.

Dans chacune de ces figures on a représenté trois dispositions différentes des éléments 1 et 2 entre eux.

Dans une forme classique une cabine électrique métallique suivant l'invention est constituée par une enceinte métallique entourée par une enceinte isolante, qui assure la fonction d'écran de tension de pas ou de contact.

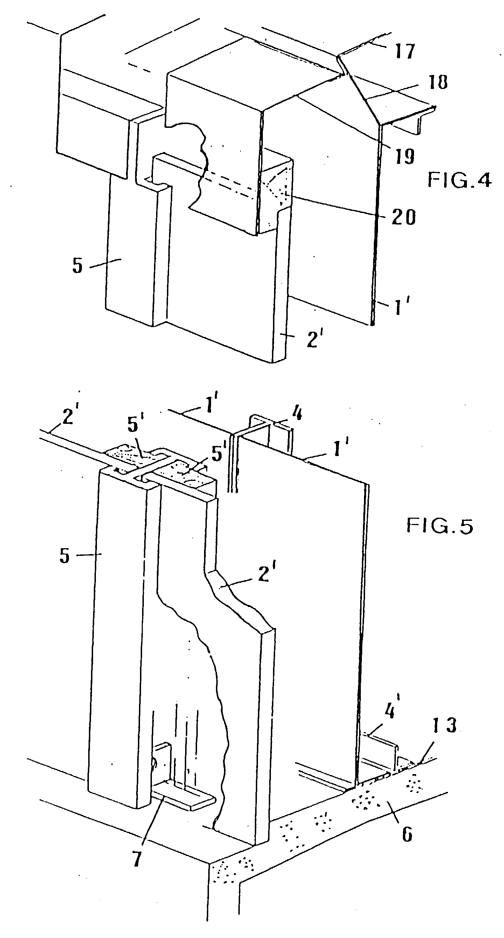

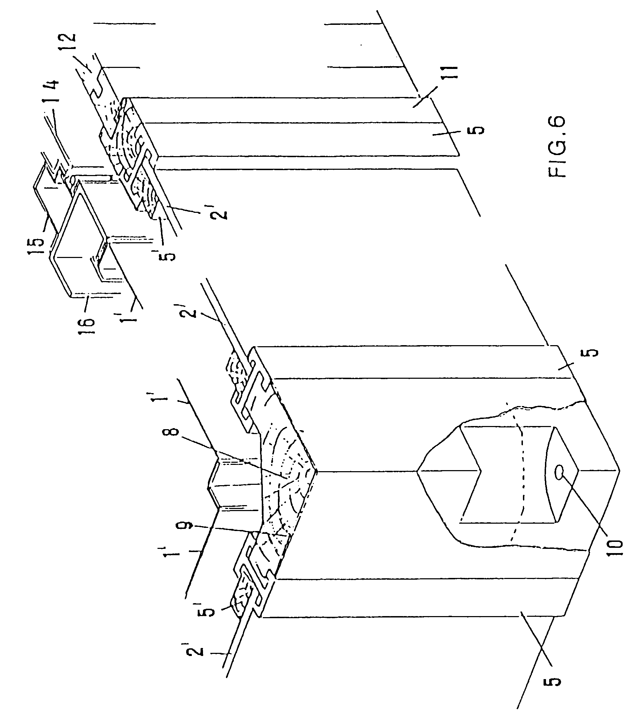

Une réalisation et une disposition suivant la figure 1A sont représentées de manière détaillée dans les figures 4 à 6. On voit la paroi de cabine formée de l'élément métallique conducteur 1 et de l'élément isolant 2. Les éléments 1 sont constitués d'un assemblage de panneaux ou modules verticaux 1' reliés entre eux par des rails 4 en forme de T servant à augmenter leur résistance à la flexion et permettant la fixation du matériel électrique. Ils sont reliés entre eux à la base par des barres 4' en forme de L, qui constituent l'infrastructure intérieure de la cabine assurant la rigidité de l'ensemble.

De leur côté les éléments 2 sont constitués d'un assemblage de panneaux ou modules verticaux isolants 2' reliés entre eux par des piquets de clôture isolants 5 en forme de I, dans lesquels ils sont calés par des pièces mortaisées en bois 5'.

Ces piquets 5 remplissent les fonctions suivantes :
- jonction et assemblage de deux panneaux isolants consécutifs 2' pour la constitution de l'élément isolant 2 ;
- fixation de l'élément isolant 2 au socle en béton 6 servant d'assise à la cabine par un moyen de fixation 7 en forme de L ;
- fixation de l'élément isolant 2 à des pièces de coin 8 en bois ou matière plastique isolante et résiliente, protégées extérieurement par des pièces métalliques angulaires 9 et fixées au sol en 10 ;
- assemblage de l'élément isolant 2 et d'un montant 11 constituant le chambranle d'une porte 12 en bois permettant le passage à travers l'enceinte isolante.

Le sol de la cabine est recouvert d'un tapis isolant 13.

L'aspect extérieur de l'enceinte isolante est modifiable arbitrairement selon le type de peinture, crépi ou revêtement minéral, organique ou synthétique choisi. Ceci permet une adaptation du style de la cabine aux exigences urbanistiques et de l'environnement les plus diverses.

L'enceinte métallique 1 est également pourvue d'une porte métallique 14 correspondant à la porte 12 de l'enceinte isolante 2 et reliée aux panneaux métalliques 1' par des éléments de chambranle 15,16.

Ces portes d'accès 12, 14 à la cabine sont munies d'un système de blocage en position totalement ouverte.

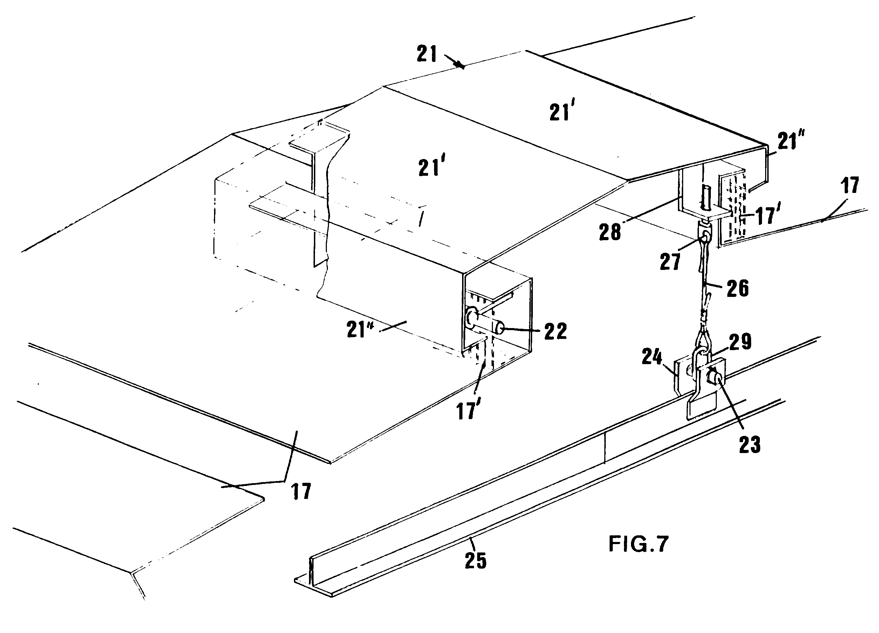

La cabine métallique reliée à la terre et servant de cage de Faraday est coiffée d'un toit, qui peut être métallique ou en matière isolante composite. On a représenté en figure 7 et 4 une réalisation de toiture métallique pour une cabine suivant l'invention.

La toiture représentée est reliée à l'enceinte métallique 1 par la partie inférieure de panneaux 17 constitutifs de la pente de toiture et par des pièces métalliques en V 18. Sur le bord des panneaux 17 est montée une bordure de toiture 19 protégée contre le fléchissement par une pièce en bois 20 chevauchant les panneaux isolants 2'.

Les panneaux de toiture 17 se terminent à leur partie supérieure en forme de L renversé. Cette forme des deux côtés de la ligne faîtière constitue en conjonction avec un chapiteau 21 deux ouvertures assurant l'aération permanente de la cabine, ouvertures servant de logement à un treillis de protection 17' constituant une chicane pour les insectes et les petits animaux. Cette forme constitue également une chicane contre les effets des intempéries.

Le chapiteau de toiture 21 est constitué de deux plans 21' adjacents par la ligne de faîte suivant un angle obtus. Il se termine à la base par des cornières en L 21" se faisant vis-à-vis.

Ce chapiteau 21 est monté de manière articulée à l'une de ces extrémités en L sur un axe fixe 22 porté par l'extrémité en L du panneau de toiture correspondant 17. L'autre extrémité en L du chapiteau 21 est montée de manière libre mais est verrouillée par un système à axe fusible. L'axe fusible 23 est monté dans un cavalier 24 fixé à une poutre 25, faisant partie de l'infrastructure intérieure de la cabine, et relie par un câble 26 et un tendeur de câble 27 à une pièce 28 du chapiteau 21. Le câble 26 est en liaison avec l'axe fusible 23 par un anneau 29 constituant un chaînon de moindre résistance.

En conditions de surpression le chapiteau mobile 21 permet l'évacuation de l'air chaud de la cabine. L'ouverture du chapiteau s'effectue par fusion de l'axe 23 ou par rupture de l'anneau 29, ceci sous l'action de la force de traction résultant de l'excédent de pression provoqué par un court-circuit ou tout autre cause.

On peut citer d'autres moyens, non représentés aux dessins, permettant l'évacuation des calories :
- un ventilateur, situé dans la partie supérieure de la cabine, et une grille de sortie d'air, équipée de chicanes antipluie et prévue dans la paroi de la cabine en regard du ventilateur ;
- un assemblage de panneaux constitutifs de la cabine selon une structure en accordéon ;
- un couvercle en matière isolante, retenu par des chaînes et scellé dans la toiture ou le sol par l'intermédiaire d'une jointure présentant des propriétés mécaniques de moindre résistance par rapport à l'ensemble et provoquant une ouverture réversible en cas de court-circuit.

La toiture surplombe et protège l'enceinte isolante grâce à la bordure de toiture 18 qui, démontable, donne accès aux panneaux isolants 2' également démontables. Ceci permet, le cas échéant, le remplacement d'un panneau modulaire isolant.

Tout en assurant les mêmes fonctions que la toiture métallique, une toiture en matière isolante composite peut être utilisée.

Dans une autre réalisation, où l'enceinte métallique sert de cage de Faraday et d'infrastructure intérieure, l'enceinte extérieure isolante supporte la toiture, également en matière isolante, et c'est ce dernier ensemble qui circonscrit et absorbe les contraintes mécaniques en cas de surpression.

## Revendications

1. Cabine électrique métallique comportant des parois comprenant des panneaux métalliques (1') qui forment par leur assemblage une enceinte métallique (1) raccordée électriquement à la terre, caractérisée en ce que les parois comprennent de plus des panneaux électriquement isolants (2') qui, disposés à l'intérieur de l'enceinte métallique (1) et/ou autour de celle-ci, forment par leur assemblage au moins une enceinte ou couche électriquement isolante (2) de barrage permanent entre l'enceinte métallique (1) et un être vivant situé respectivement soit à l'intérieur de la cabine soit hors de celle-ci.

2. Cabine électrique selon la revendication 1 caractérisée en ce que l'enceinte ou couche électriquement isolante (2) est espacée des panneaux métalliques (1').

3. Cabine électrique selon la revendication 1, caractérisée en ce que l'enceinte ou couche électriquement isolante (2) est en contact avec les panneaux métalliques (1').

4. Cabine électrique selon l'une quelconque des revendication 1 à 3, caractérisée en ce qu'une paroi est pourvue d'une porte métallique (14) et/ou en matière électriquement isolante (12).

5. Cabine électrique selon l'une quelconque des revendication 1 à 4, caractérisée en ce que le sol est recouvert d'un tapis isolant.

6. Cabine électrique selon l'une quelconque des revendications 1 à 5, caractérisée en ce que son enceinte est coiffée d'un toit métallique et/ou en matière électriquement isolante.

7. Cabine électrique selon l'une quelconque des revendications 1 à 6, caractérisée en ce que le raccordement à l'électrode de terre des panneaux métalliques (1') est équipé d'un système de mesure de la résistance de l'électrode de terre qui déclenche un signal d'avertissement indiquant la présence d'une anomalie et/ou qui bloque l'accès de la cabine en cas de défectuosité.

8. Cabine électrique selon l'une quelconque des revendications 1 à 7, caractérisée en ce qu'elle est équipée de moyens d'évacuation des calories et d'un excédent de pression survenant lors d'un court-circuit; ces moyens étant constitués d'un clapet mobile ou d'un couvercle scellé en matière isolante.

9. Cabine électrique selon l'une quelconque des revendications 1 à 8 caractérisée en ce qu'elle est équipée de moyens de dissipation de l'énergie calorifique produite en son enceinte, constitués par des panneaux avec une structure en accordéon.

10. Cabine électrique selon l'une quelconque des revendications 1 à 8, caractérisée en ce que les couches électriquement isolantes forment ou sont recouvertes de parements urbanistiques.

## Patentansprüche

1. Elektrische Metallkabine mit Wänden, die metallische Tafeln (1') aufweisen, die aufgrund ihrer Zusammenstellung eine metallische Umhüllung (1) bilden, die elektrisch mit Erde verbunden ist, dadurch gekennzeichnet, daß die Wände weiterhin elektrisch isolierende Tafeln (2') aufweisen, die im Inneren der metallischen Umhüllung (1) und/oder um diese herum angeordnet sind und aufgrund ihrer Zusammenstellung zumindest eine elektrisch isolierende Umhüllung oder Schicht als permanente Sperre zwischen der metallischen Umhüllung (1) und einem Lebewesen bilden, das sich entweder im Inneren der Kabine oder außerhalb dieser befindet.

2. Elektrische Kabine nach Anspruch 1, dadurch gekennzeichnet, daß die elektrisch isolierende Umhüllung oder Schicht (2) von den metallischen Tafeln (1') einen Abstand aufweist.

3. Elektrische Kabine nach Anspruch 1, dadurch gekennzeichnet, daß die elektrisch isolierende Umhüllung oder Schicht (2) im Kontakt mit den metallischen Tafeln (1') steht.

4. Elektrische Kabine nach einem der Ansprüche 1 bis 3, dadurch gekennzeichnet, daß eine Wand mit einer metallischen (14) und/oder aus elektrisch isolierendem Material (12) bestehenden Tür versehen ist.

5. Elektrische Kabine nach einem der Ansprüche 1 bis 4, dadurch gekennzeichnet, daß der Boden mit einem isolierenden Teppich bedeckt ist.

6. Elektrische Kabine nach einem der Ansprüche 1 bis 5, dadurch gekennzeichnet, daß ihre Umhüllung mit einem metallischen und/oder aus elektrisch isolierendem Material bestehenden Dach abgedeckt ist.

7. Elektrische Kabine nach einem der Ansprüche 1 bis 6, dadurch gekennzeichnet, daß der Anschluß an der Erdelektrode der metallischen Tafeln (1') mit einem System zur Messung des Widerstands der Erdelektrode versehen ist, das ein Warnsignal auslöst, das die Anwesenheit einer Störung anzeigt und/oder den Zugang zur Kabine im Fall eines Fehlers blockiert.

8. Elektrische Kabine nach einem der Ansprüche 1 bis 7, dadurch gekennzeichnet, daß sie mit einer Einrichtung zur Abfuhr von bei einem Kurzschluß auftretenden Kalorien und eines Drucküberschusses versehen ist, wobei diese Einrichtung aus einer beweglichen Klappe oder aus einem luftdicht eingesetzten Deckel aus isolierendem Material besteht.

9. Elektrische Kabine nach einem der Ansprüche 1 bis 8, dadurch gekennzeichnet, daß sie mit einer Einrichtung zur Dissipation von in ihrer Umhüllung erzeugter Wärmeenergie versehen ist, die aus Tafeln mit einer ziehharmonikaartigen Struktur besteht.

10. Elektrische Kabine nach einem der Ansprüche 1 bis 8, dadurch gekennzeichnet, daß die elektrisch isolierenden Schichten städtebauliche Verkleidungen bilden oder mit solchen abgedeckt sind.

## Claims

1. A metal electrical cabinet having walls comprising metal panels (1') which together form a metal enclosure (1) connected electrically to earth, characterised in that the walls further comprise electrically insulating panels (2') which, arranged inside the metal enclosure (1) and/or around it, together form at least one electrically insulating enclosure or layer (2) forming a permanent barrier between the metal enclosure (1) and a human being situated respectively either inside the cabinet or outside thereof.

2. A metal electrical cabinet according to Claim 1, characterised in that the electrically insulating enclosure or layer (2) is spaced apart from the metal panels (1').

3. A metal electrical cabinet according to Claim 1, characterised in that the electrically insulating enclosure or layer (2) is in contact with the metal panels (1').

4. A metal electrical cabinet according to any one of Claims 1 to 3, characterised in that one wall is provided with a metal door (14) and/or of electrically insulating material (12).

5. A metal electrical cabinet according to any one of Claims 1 to 4, characterised in that the floor is covered with an insulating mat.

6. A metal electrical cabinet according to any one of Claims 1 to 5, characterised in that its enclosure is covered with a metal roof and/or of electrically insulating material (12).

7. A metal electrical cabinet according to any one of Claims 1 to 6, characterised in that the connection to the earth electrode of the metal panels (1') is provided with a system for measuring the resistance of the earth electrode, which triggers a warning signal indicating the presence of a fault and/or which prevents access to the cabinet if a defect occurs.

8. A metal electrical cabinet according to any one of Claims 1 to 7, characterised in that it is provided with means for dissipating heat and excess pressure occurring in the event of a short-circuit, said means comprising a movable flap valve or a sealed cover of insulating material.

9. A metal electrical cabinet according to any one of Claims 1 to 8, characterised in that it is provided with means for dissipating the thermal energy produced in its enclosure, said means comprising panels with a concertina-type structure.

10. A metal electrical cabinet according to any one of Claims 1 to 8, characterised in that the electrically insulating layers form or are covered with environmentally acceptable facings.
